# EUROPÄISCHE PATENTANMELDUNG

(11) **EP 3 629 047 A1**
(43) Veröffentlichungstag der Anmeldung: **01.04.2020**
(21) Anmeldenummer: 18197267.0
(22) Anmeldetag: 27.09.2018
(51) Int. Cl.: G01R 33/56, G01R 33/561

(54) **MAGNETRESONANZ-FINGERPRINTING-VERFAHREN BASIEREND AUF ÄHNLICHKEITSWERTEN**

(71) Anmelder: Siemens Healthcare GmbH, 91052 Erlangen (DE)
(72) Erfinder: Körzdörfer, Gregor, 91058 Erlangen (DE); Nittka, Mathias, 91083 Baiersdorf (DE); Speier, Peter, 91056 Erlangen (DE); Wetzl, Jens, 91080 Spardorf (DE)

(57) **Zusammenfassung**

Bei dem erfindungsgemäßen Magnetresonanz-Fingerprinting-Verfahren werden Parameterwerte nicht wie bisher üblich durch eine 1:1-Zuordnung mit einem Vergleichssignalverlauf bestimmt, sondern auf Basis von mindestens 2 zuvor bestimmten ähnlichsten Vergleichssignalverläufen. Dadurch können die zu bestimmenden Parameter mit einer Auflösung bestimmt werden, die größer ist als die den Vergleichssignalverläufen zugrunde liegende Auflösung der Werte der zu bestimmenden Parameter. Somit sind die als Ergebnis der Bestimmung der Parameterwerte möglichen Werte durch das erfindungsgemäße Vorgehen nicht auf die Werte der Vergleichssignalverläufe, also nicht auf das Raster/Gitter des Dictionarys, beschränkt.

## Beschreibung

Die Erfindung betrifft ein Magnetresonanz-Fingerprinting-Verfahren zur verbesserten Bestimmung von lokalen Parameterwerten eines Untersuchungsobjektes.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einem Magnetresonanzgerät in einem vergleichsweise starken statischen, homogenen Grundmagnetfeld, auch B₀-Feld genannt, mit Feldstärken von 0,2 Tesla bis 7 Tesla und mehr positioniert, so dass sich dessen Kernspins entlang des Grundmagnetfeldes orientieren. Zum Auslösen von Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld schnell geschaltete magnetische Gradientenfelder überlagert, die die Trajektorien festlegen, entlang derer die Messdaten im k-Raum ausgelesen werden. Die aufgezeichneten Messdaten werden digitalisiert und als komplexe Zahlenwerte in einer k-Raum-Matrix abgelegt. Aus der mit Werten belegten k-Raum-Matrix ist z.B. mittels einer mehrdimensionalen Fourier-Transformation ein zugehöriges MR-Bild rekonstruierbar. Eine hierzu verwendete auf bestimmte Art und Weise geordnete Folge von einzustrahlenden RF-Pulsen, zu schaltenden Gradienten und Auslesevorgängen wird als Sequenz bezeichnet.

Es sind verschiedene Sequenztypen bekannt, die unterschiedlich sensitiv auf die in einem untersuchten Untersuchungsobjekt enthaltenen Stoffe beschreibende Parameter (z.B. die longitudinale Longitudinalrelaxation T1, die Transversalrelaxation T2 und die Protonendichte) sind. Die aus mit einem bestimmten Sequenztypen aufgenommenen Messdaten rekonstruierten MR-Bilder zeigen entsprechend der Sensitivitäten des verwendeten Sequenztyps gewichtete Abbildungen des Untersuchungsobjektes.

Eine Magnetresonanz-Bildgebung mittels einer Magnetresonanzanlage kann dazu dienen, eine Anwesenheit und/oder eine Verteilung eines Stoffs, welcher sich in einem Untersuchungsobjekt befindet, zu bestimmen. Der Stoff kann dabei beispielsweise ein, möglicherweise pathologisches, Gewebe des Untersuchungsobjekts, ein Kontrastmittel, eine Markierungssubstanz oder ein Stoffwechselprodukt sein.

Informationen über die vorliegenden Stoffe können dabei auf vielfältige Weise aus den aufgenommenen Messdaten gewonnen werden. Eine relativ einfache Informationsquelle sind z.B. aus den Messdaten rekonstruierte Bilddaten. Es gibt jedoch auch komplexere Verfahren, die, z.B. aus Bildpunkt-Zeit-Serien von aus sukzessive gemessenen Messdatensätzen rekonstruierten Bilddaten, Informationen über das untersuchte Untersuchungsobjekt ermitteln.

Mit Hilfe von quantitativen MR-Bildgebungstechniken lassen sich absolute Eigenschaften des gemessenen Objekts bestimmen, z.B. die gewebespezifische T1- und T2-Relaxation am Menschen. Im Gegensatz dazu erzeugen die in der klinischen Routine meist verwendeten konventionellen Sequenzen lediglich eine relative Signalintensität unterschiedlicher Gewebetypen (sogenannte Wichtungen), so dass die diagnostische Interpretation in hohem Maße der subjektiven Einschätzung des Radiologen unterliegt. Quantitative Techniken bieten somit den offensichtlichen Vorteil einer objektiven Vergleichbarkeit, finden aber aufgrund langer Messzeiten derzeit in der Routine kaum Verwendung.

Neuere quantitative Messverfahren wie Magnetresonanz-Fingerprinting-Verfahren (MRF-Verfahren), könnten den genannten Nachteil der langen Messzeiten auf ein akzeptables Maß senken. Bei MRF-Verfahren werden zeitlich nacheinander mit verschiedenen Aufnahmeparametern Messdaten aufgenommenen. Aus den nacheinander aufgenommenen Messdaten wird eine Serie von Bilddaten rekonstruiert. Ein Signalverlauf jeweils eines der Bildpunkte der Serien von Bilddaten wird als Bildpunkt-Zeit-Serie betrachtet. Hierbei kann der Signalverlauf für alle oder zumindest für interessierende Bildpunkte der Bilddaten untersucht werden. Ein solcher Signalverlauf einer Bildpunkt-Zeit-Serie wird hierbei oft als "Fingerabdruck" (engl. "fingerprint") des in dem jeweiligen Bildpunkt dargestellten Ortes des Untersuchungsobjektes bezeichnet. Ein derartiger Signalverlauf kann genutzt werden, um die während der Messung in dem durch den Bildpunkt dargestellten Ort des Untersuchungsobjekts vorliegenden Parameter zu bestimmen.

Dazu werden diese Signalverläufe mittels Mustererkennungsverfahren ("pattern recognition") mit Signalverläufen einer zuvor ermittelten Datenbank von für bestimmte Stoffe charakteristischen Signalverläufen (dem sogenannten "Dictionary") verglichen. Somit können die in den aus den Messdaten rekonstruierten Bilddaten repräsentierten Stoffe bzw. die räumliche Verteilung von gewebespezifischen Parametern (wie die Transversalrelaxation T2, die effektive Transversalrelaxation T2* oder die Longitudinalrelaxation T1; sogenannte T2, T2*- und T1-Karten) in dem abgebildeten Untersuchungsobjekt ermittelt werden. Die in einem derartigen Dictionary enthaltenen Signalverläufe können hierbei auch durch Simulationen erstellt worden sein.

Das Prinzip dieser Methode ist somit, gemessene Signalverläufe mit einer Vielzahl im Voraus bekannter Signalverläufe zu vergleichen. Dabei können Signalverläufe für verschiedene Kombinationen aus T1- und T2-Relaxationszeiten sowie auch anderen Parametern für das Dictionary ermittelt worden sein. Man spricht von je einer "Dimension" des Dictionarys für jeden zu bestimmenden Parameter, in der verschiedene Parameterwerte des jeweiligen Parameters umfasst sind, um verschiedene Vergleichswerte zur Verfügung zu stellen. Die Parameterwerte, z.B. T1- und T2-Zeiten, eines Bildpunktes (Pixels/Voxels) im Bild werden dann insbesondere bestimmt, indem der gemessene Signalverlauf mit allen oder einem Teil der simulierten Signalverläufe verglichen wird. Dieser Vorgang wird als "Matching" bezeichnet. Derjenige Signalverlauf des Dictionarys, der dem gemessenen Signalverlauf am ähnlichsten ist, determiniert in bekannten MRF-Verfahren die Parameter, z.B. Relaxationsparameter T1 und T2, des jeweiligen Bildpunktes. Eine derartige Bestimmung der Parameterwerte wird im Zusammenhang mit MRF-Techniken auch als Rekonstruktion bzw. Rekonstruktionsprozess bezeichnet.

Grundsätzlich können dabei neben den bereits genannten gewebespezifischen Parametern eines untersuchten Objektes auch messungsspezifische Parameter, wie z.B. die Feldstärken der applizierten Magnetfelder oder auch die lokale Verteilung der Stärke eines eingestrahlten Hochfrequenzfeldes B1+, ermittelt werden, da mittels MR-Techniken aufgenommene Signale von den in einem untersuchten Objekt vorliegenden gewebespezifischen Parametern sowie von messungsspezifischen Parametern, die die während der Messung vorliegenden Bedingungen beschreiben, abhängen können. Die verwendeten Aufnahmeparameter sind hierbei derart gewählt, dass die aufgenommenen Messdaten eine Abhängigkeit von den gewünschten zu bestimmenden Parametern zeigen. Beispielsweise können Sequenztypen für das MRF-Verfahren eingesetzt werden, die sensitiv auf die gewünschten Parameter sind. Durch die Abhängigkeiten und die Variation der Aufnahmeparameter und deren Berücksichtigung in den Vergleichssignalverläufen sind die gewünschten Parameter aus derartig aufgenommenen Bildpunkt-Zeit-Serien bestimmbar.

Für MRF-Verfahren kann grundsätzlich jede Echotechnik (insbesondere Spinecho(SE)-Techniken und Gradientenecho(GRE)-Techniken) in Kombination mit jeglichen Verfahren zur k-Raumabtastung (z.B. kartesisch, spiralförmig, radial) benutzt werden.

Ein MRF-Verfahren, das die gewebespezifischen Parameter T1 und T2 in dem verwendeten Dictionary berücksichtigt und in gemessenen Bildpunkt-Zeit-Serien bestimmt, ist beispielsweise in dem Artikel von Ma et al., "Magnetic Resonance Fingerprinting", Nature, 495: S. 187-192 (2013) beschrieben. Dort wird eine TrueFISP ("true fast imaging with steady-state free precession") basierte Sequenz in Kombination mit einer spiralförmigen k-Raumabtastung benutzt.

Eine andere MRF-Implementierung wird von Jiang et al. in dem Artikel ""MR Fingerprinting Using Fast Imaging with Steady State Precession (FISP) with Spiral Readout", Magnetic Resonance in Medicine 74: S. 1621-1631, 2015, beschrieben. Dort wird eine FISP-Sequenz ("Fast Imaging with Steady State Precession") in Kombination mit einer Spiral-Abtastung verwendet: Nach einem adiabatischen 180° RF-Inversionspuls zur gezielten Störung des Gleichgewichtzustandes der Spins wird eine Folge von RF-Anregungspulsen mit pseudorandomisierten Flipwinkeln appliziert und jedes jeweils nach einem der RF-Anregungspulse resultierende Echo mit einer einzelnen spiralförmigen k-Raumtrajektorie ausgelesen. Es werden n RF-Anregungspulse benutzt, die ebenso viele Echos erzeugen. Aus den entlang der jeweiligen k-Raumtrajektorie aufgenommenen Messdaten jedes Echos wird ein Einzelbild rekonstruiert. Aus den n Einzelbildern wird für jeden Bildpunkt ein Signalverlauf extrahiert, der mit den simulierten Verläufen verglichen wird. Der zeitliche Abstand TR zwischen zwei aufeinanderfolgenden RF-Anregungspulsen der n RF-Anregungspulse kann hierbei ebenfalls, z.B. pseudorandomisiert, variiert werden.

Ein wichtiger Aspekt bei MRF-Techniken, der diese von anderen quantitativen MR-Verfahren unterscheidet, ist die Bestimmung des genannten Dictionarys. Wie bereits erwähnt, wird der Dictionary häufig erstellt, indem verschiedene mögliche Vergleichssignalverläufe, z.B. durch Simulation, insbesondere auf Basis der Bloch-Gleichungen, vorberechnet werden. Im Gegensatz dazu werden bei anderen quantitativen Methoden zur Bestimmung von Parameterwerten mittels MR in der Regel die gemessenen Signale an ein Modell gefittet. Eine Simulation von Signalverläufen, die einen MRF-Dictionary bilden sollen, muss nur einmalig durchgeführt werden und nicht, wie bei anderen quantitativen Methoden bei jeder Messung ein erneuter Fit durchgeführt werden. Dadurch können deutlich komplexere Signalmodelle benutzt werden und dennoch die Rekonstruktionszeiten klein gehalten werden.

Mit zunehmender Komplexität der Simulation von Vergleichssignalverläufen (z.B. bezüglich der Anzahl der einbezogenen Parameter und/oder bezüglich der Auflösung der möglichen Werte der Parameter) steigt jedoch die Zeit, die für die Simulation eines Dictionarys benötigt wird. Ähnliches gilt für die Rekonstruktion, da der Zeitaufwand für das Matching ebenfalls mit der Anzahl der in einem Dictionary enthaltenen Vergleichssignalverläufen steigt.

Es sind bereits Verfahren bekannt, bei welchen das verwendete Dictionary vorbereitet und in verschiedene Untergruppen unterteilt wird, wobei dann zunächst in einem ersten Schritt die am wenigsten ähnlichen Untergruppen aussortiert werden, um so die Zahl der beim Matching in einem zweiten Schritt nötigen Vergleiche zu reduzieren. Ein derartiges Verfahren ist beispielsweise in dem Artikel von Cauley S et al, "Fast group matching for MR fingerprinting reconstruction", Magnetic Resonance in Medicine 74:523-528, 2015. Eine weitere Möglichkeit, den bei der Rekonstruktion zu treibenden Aufwand gering zu halten, ist es eine "Annähernd-Nächster-Nachbar"- Suche (engl. "approximate nearest neighbour" search) zu verwenden, bei Zeitpunkte von gemessenen MRF-Signalverläufen mit entsprechenden Zeitpunkten der im Dictionary enthalten Vergleichssignalverläufe verglichen werden, und anhand der Ergebnisse dieses Vergleichs entschieden wird, welche Zeitpunkte als nächstes verglichen werden sollen. Ein derartiger Ansatz wird beispielsweise in dem Artikel von Cline C et al, "AIR-MRF: Accelerated iterative reconstruction for magnetic resonance fingerprinting", Magnetic Resonance Imaging 41:29-40, 2017, beschrieben.

Weiterhin gibt es bereits Ideen, die versuchen anstatt eines Matchings völlig andere Ähnlichkeitsmessungen zu verwenden, von denen man sich erhofft, dass sie schneller durchgeführt werden können. Ein derartiges Verfahren wird z.B. in dem Artikel von Hoppe E. et al, "Deep Learning for Magnetic Resonance Fingerprinting: A New Approach for Predicting Quantitative Parameter Values from Time Series", Studies in Health Technology and Informatics 243:202-206, 2017, beschrieben.

Der Erfindung liegt die Aufgabe zugrunde den für einen MRF-Rekonstruktionsprozess notwendigen Zeitaufwand zu reduzieren, ohne dessen Qualität zu senken.

Die Aufgabe wird gelöst durch ein Verfahren zur Bestimmung von Parameterwerten in Bildpunkten eines Untersuchungsobjektes mittels einer Magnetresonanz-Fingerprinting(MRF)-Technik gemäß Anspruch 1, eine Magnetresonanzanlage gemäß Anspruch 10, ein Computerprogramm gemäß Anspruch 11 sowie einen elektronisch lesbaren Datenträger gemäß Anspruch 12.

Ein erfindungsgemäßes Verfahren zur Bestimmung von Parameterwerten in Bildpunkten eines Untersuchungsobjektes mittels einer Magnetresonanz-Fingerprinting(MRF)-Technik umfasst die Schritte:
- Laden von einer Anzahl N an Vergleichssignalverläufen (D), die jeweils vorgegebenen Werten der zu bestimmenden Parameter zugeordnet sind,
- Erfassen mindestens einer Bildpunkt-Zeit-Serie (BZS) des Untersuchungsobjekts mit Hilfe eines MRF-Aufnahmeverfahrens, die mit den geladenen Vergleichssignalverläufen vergleichbar sind,
- Durchführen eines Signalvergleichs (105) mindestens eines Abschnitts des jeweiligen Signalverlaufs der erfassten Bildpunkt-Zeit-Serien (BZS) mit einem entsprechenden Abschnitt der geladenen Vergleichssignalverläufe (D) zur Ermittlung von Ähnlichkeitswerten (V) der erfassten Bildpunkt-Zeit-Serie (BZS) mit den geladenen Vergleichssignalverläufen (D),
- Bestimmen einer zweiten Anzahl n, wobei 2 ≤ n (≤ N), von ähnlichsten Vergleichssignalverläufen (d) der geladenen Vergleichssignalverläufen (D) mit den n höchsten bestimmten Ähnlichkeitswerten (V),
- Bestimmen der Werte (P) der zu bestimmenden Parameter auf Basis der n bestimmten ähnlichsten Vergleichssignalverläufe (d),
- Speichern und/oder Ausgeben der für den jeweiligen Bildpunkt bestimmten Werte (P) der zu bestimmenden Parameter.

Durch die erfindungsgemäße Bestimmung von Parameterwerten, nicht wie bisher durch 1:1-Zuordnung mit einem Vergleichssignalverlauf, sondern auf Basis von mindestens 2 zuvor bestimmten ähnlichsten Vergleichssignalverläufen, können die zu bestimmenden Parameter mit einer Auflösung bestimmt werden, die größer ist als die den Vergleichssignalverläufen zugrunde liegende Auflösung der Werte der zu bestimmenden Parameter. Somit sind die als Ergebnis der Bestimmung der Parameterwerte möglichen Werte durch das erfindungsgemäße Vorgehen nicht auf die Werte der Vergleichssignalverläufe, also nicht auf das Raster/Gitter des Dictionarys, beschränkt.

Dadurch kann entweder der bei der Gewinnung der Vergleichssignalverläufe zu betreibende Aufwand gering gehalten werden, ohne dass die Genauigkeit der letztendlich bestimmten Parameterwerte darunter leiden müsste, wodurch insbesondere der Zeitaufwand für die Erstellung, z.B. Simulation, eines MRF-Dictionarys und für den MRF-Rekonstruktionsprozess ohne signifikante Qualitätseinbußen gesenkt werden kann. Oder es kann die Genauigkeit der Bestimmung der Werte der zu bestimmenden Parameter erhöht werden, ohne dass weitere Vergleichssignalverläufe nötig werden. Insgesamt kann somit der Rechenaufwand sowie auch der Zeitaufwand bereits bei der Gewinnung der Vergleichssignalverläufe im Verhältnis zu der erreichbaren Genauigkeit der rekonstruierten Parameterwerte gering gehalten oder sogar reduziert werden, z.B. weil weniger Vergleichssignalverläufe simuliert oder gemessen werden müssen, um eine gewünschte Auflösung der Parameterwerte zu erreichen. Ebenso kann somit der Rechen- und Zeitaufwand bei der Rekonstruktion der Parameterwerte reduziert werden, z.B. weil weniger Vergleichsoperationen bei gleicher Genauigkeit der Bestimmung der Parameterwerte durchgeführt werden müssen.

Genügt hiermit eine kleinere Anzahl an Vergleichssignalverläufen, also ein kleineres Dictionary mit gröber aufgelöstem Raster, für die gewünschte Bestimmung der Werte der Parameter, ist auch der Speicherbedarf für das Dictionary reduziert.

Hierbei kann die zweite Anzahl n größer gewählt werden als die Anzahl der verschiedenen zu bestimmenden Parameter, um mehr Freiheit in den als Ergebnis der Bestimmung möglichen Parameterwerten zu schaffen.

Insbesondere kann die zweite Anzahl n um eins größer gewählt werden als die Anzahl der verschiedenen zu bestimmenden Parameter. Somit kann der Rechenaufwand weiter gering gehalten werden und gleichzeitig bereits eine weit höhere Genauigkeit bei der Bestimmung der Parameterwerte erzielt werden als bei einer bisher üblichen 1:1-Zuordnung von einer aufgenommenen Bildpunkt-Zeit-Serie zu einem Vergleichssignalverlauf.

Ein Ähnlichkeitswert einer erfassten Bildpunkt-Zeit-Serie mit einem der geladenen Vergleichssignalverläufe ist hierbei ein Maß einer Übereinstimmung der erfassten Bildpunkt-Zeit-Serie mit dem betrachteten Vergleichssignalverlauf. Derartige Ähnlichkeitswerte werden im Rahmen des MRF-Matchings benutzt, um denjenigen Vergleichssignalverlauf zu bestimmen, der mit einer erfassten Bildpunkt-Zeit-Serie am meisten übereinstimmt, und somit die größte Ähnlichkeit, d.h. den höchsten Ähnlichkeitswert, aufweist. Als derartiges Maß können grundsätzlich alle auch für Vektoren bekannte Ähnlichkeitsmaße verwendet werden.

Das Bestimmen eines Ähnlichkeitswerts einer erfassten Bildpunkt-Zeit-Serie mit einem der geladenen Vergleichssignalverläufe kann eine Berechnung des inneren Produkts der Bildpunkt-Zeit-Serie und des geladenen Vergleichssignalverlaufs umfassen. Das innere Produkt, auch Skalarprodukt genannt, ist eine einfach zu berechnende Größe, die einen skalaren Wert liefert, der ausreichend gut als Ähnlichkeitswert geeignet ist.

Das Bestimmen der Werte der zu bestimmenden Parameter auf Basis der n bestimmten ähnlichsten Vergleichssignalverläufe kann eine Mittelung umfassen. Eine Mittelung ist leicht zu berechnen und liefert die zentrale Tendenz einer Verteilung, und damit eine gute Näherung der gesuchten Werte.
Zur Mittelung kann grundsätzlich jede Art von Mittelung, also z.B. eine Bildung des arithmetischen Mittelwertes, des geometrischen Mittelwertes (n-te Wurzel aus dem Produkt der n betrachteten Werte), des quadratischen Mittelwertes (RMS, engl. "root mean square") oder auch ein Median, bestimmt werden. Welche Art der Mittelung gewählt wird, kann davon abhängen, welche zentrale Tendenz abgebildet werden soll.

Das Bestimmen der Werte der zu bestimmenden Parameter auf Basis der n bestimmten ähnlichsten Vergleichssignalverläufe kann eine Wichtung umfassen. Über eine Wichtung kann das Ergebnis der Bestimmung der Werte der zu bestimmenden Parameter, z.B. gemäß weiterer bekannter Umstände oder Bedingungen, beeinflusst werden.

Die Wichtung kann auf Basis der bestimmten Ähnlichkeitswerte bestimmt werden. Somit kann das Ergebnis der Bestimmung der Werte der zu bestimmenden Parameter näher an diejenigen den Vergleichssignalverläufen zugeordneten Werte gebracht werden, die einen höheren Ähnlichkeitswert aufweisen.

Es ist denkbar, dass die geladenen Vergleichssignalverläufe eine Untergruppe von einer größeren Anzahl an vorhandenen Vergleichssignalverläufen sind. Eine Bestimmung einer solchen Untergruppe kann beispielsweise wie in dem oben genannten Artikel von Cauley et al. beschrieben erfolgen.

Die geladenen Vergleichssignalverläufe können auch komprimierte Vergleichssignalverläufe sein. Eine derartige Komprimierung wird z.B. in dem Artikel von McGivney et al., "SVD Compression for Magnetic Resonance Fingerprinting in the Time Domain", IEEE Trans. Med. Imaging 33: 2311-22, 2014 beschrieben.

Eine erfindungsgemäße Magnetresonanzanlage umfasst eine Magneteinheit, eine Gradienteneinheit, eine Hochfrequenzeinheit und eine zur Durchführung eines erfindungsgemäßen Verfahrens ausgebildete Steuereinrichtung mit einer Parameterwertbestimmungseinheit.

Ein erfindungsgemäßes Computerprogramm implementiert ein erfindungsgemäßes Verfahren auf einer Steuereinrichtung, wenn es auf der Steuereinrichtung ausgeführt wird.

Das Computerprogramm kann hierbei auch in Form eines Computerprogrammprodukts vorliegen, welches direkt in einen Speicher einer Steuereinrichtung ladbar ist, mit Programmcode-Mitteln, um ein erfindungsgemäßes Verfahren auszuführen, wenn das Computerprogrammprodukt in der Recheneinheit des Rechensystems ausgeführt wird.

Ein erfindungsgemäßer elektronisch lesbarer Datenträger umfasst darauf gespeicherte elektronisch lesbare Steuerinformationen, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren angegebenen Vorteile und Ausführungen gelten analog auch für die Magnetresonanzanlage, das Computerprogramm und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:
Fig. 1 ein schematisches Ablaufdiagramm eines erfindungsgemäßen Verfahrens,
Fig. 2 eine Veranschaulichung einer möglichen Bestimmung von Parameterwerten auf Basis von bereits bestimmten ähnlichsten Vergleichssignalverläufen,
Fig. 3 eine schematisch dargestellte erfindungsgemäße Magnetresonanzanlage.

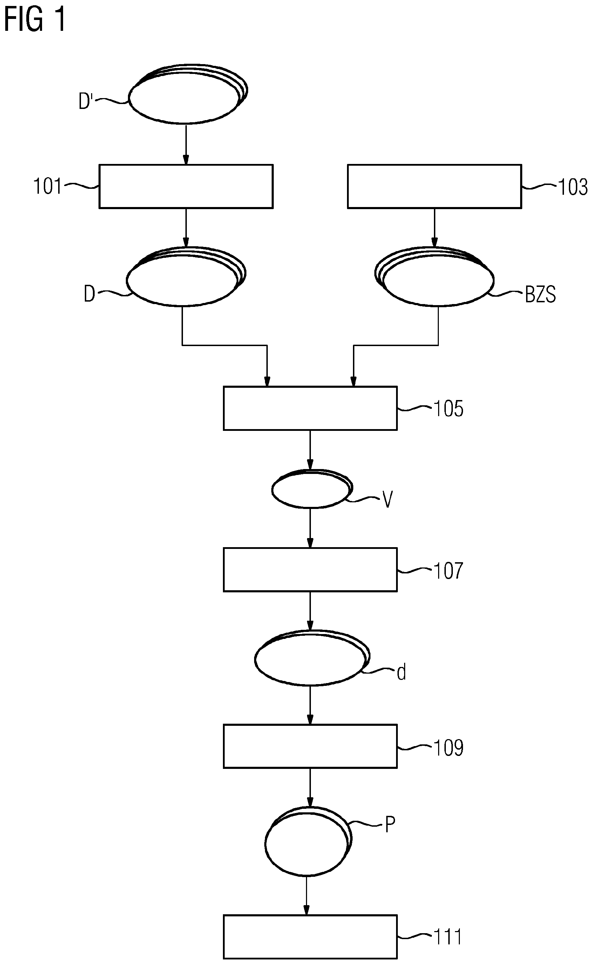

Figur 1 ist ein schematisches Ablaufdiagramm eines erfindungsgemäßen Verfahrens zur Bestimmung von Parameterwerten in Bildpunkten eines Untersuchungsobjektes mittels einer Magnetresonanz-Fingerprinting(MRF)-Technik.

Es wird eine Anzahl N an Vergleichssignalverläufen D geladen, die jeweils vorgegebenen Werten der zu bestimmenden Parameter zugeordnet sind (Block 101). Die N geladenen Vergleichssignalverläufe D wurden derart erstellt, dass gewünschte Parameter, z.B. mindestens ein gewebespezifischer oder messungsspezifischer Parameter, beispielsweise mindestens einer der Parameter umfassend die Transversalrelaxation, die Longitudinalrelaxation, die Protonendichte, die Suszeptibilität, der Magnetisierungstransfer, die Feldstärke der applizierten Magnetfelder oder die Feldstärke der applizierten Hochfrequenzfelder, bestimmt werden können.

Die geladenen N Vergleichssignalverläufe D können dabei als ein Dictionary durch Simulation oder Messung von Signalverläufen für ein Raster an bestimmten Werten der gewünschten zu bestimmenden Parameter erstellt worden sein, wobei das Raster eine Auflösung der jeweiligen Parameterwerte vorgibt.

Es ist auch möglich, dass zunächst Vergleichssignalverläufe D' erstellt wurden, und die geladenen Vergleichssignalverläufe D eine Untergruppe dieser vorhandenen Vergleichssignalverläufe D' sind. Zur Auswahl der Untergruppe kann ein Verfahren gemäß dem in dem bereits oben genannten Artikel von Cauley et al. beschriebenen Verfahren angewandt werden.

Die N geladenen Vergleichssignalverläufe D können auch komprimierte Vergleichssignalverläufe sein, die durch eine Komprimierung aus erstellten Vergleichssignalverläufen D' gewonnen wurden. Eine mögliche Art der Komprimierung ist in dem bereits oben genannten Artikel von McGivney et al. beschrieben.

Von einem in einer Magnetresonanzanlage positionierten Untersuchungsobjekt, z.B. einem Patienten, wird mindestens eine Bildpunkt-Zeit-Serie BZS mit Hilfe eines MRF-Aufnahmeverfahrens erfasst (Block 103). Hierbei werden Bildpunkt-Zeit-Serien, wie bei MRF-Verfahren üblich, auf eine Art und Weise erfasst, die es erlaubt, erfasste Bildpunkt-Zeit-Serien mit geladenen Vergleichssignalverläufen eines Dictionarys zu vergleichen.

Ein Signalvergleich mindestens eines Abschnitts des jeweiligen Signalverlaufs der erfassten Bildpunkt-Zeit-Serien BZS mit einem entsprechenden Abschnitt der geladenen Vergleichssignalverläufe D wird durchgeführt, um Ähnlichkeitswerte V der erfassten Bildpunkt-Zeit-Serien BZS mit den geladenen Vergleichssignalverläufen D zu ermitteln (Block 105).

Ein Bestimmen eines Ähnlichkeitswerts V einer erfassten Bildpunkt-Zeit-Serie BZS mit einem der geladenen Vergleichssignalverläufe D kann z.B. eine Berechnung des inneren Produkts der Bildpunkt-Zeit-Serie BZS und des geladenen Vergleichssignalverlaufs D umfassen. Insbesondere kann der Ähnlichkeitswert V einer erfassten Bildpunkt-Zeit-Serie BZS mit einem der geladenen Vergleichssignalverläufe D dem inneren Produkt der erfassten Bildpunkt-Zeit-Serie BZS mit dem betrachteten geladenen Vergleichssignalverlauf sein.

Anhand der bestimmten Ähnlichkeitswerte V wird eine zweite Anzahl n von mindestens zwei ähnlichsten Vergleichssignalverläufen d der geladenen Vergleichssignalverläufen D bestimmt, derart dass die ähnlichsten Vergleichssignalverläufe d die n besten bestimmten Ähnlichkeitswerte V aufweisen (Block 107).

Ist die zweite Anzahl n größer als die Anzahl der verschiedenen zu bestimmenden Parameter, kann anschließend der gesuchte Parameterwert mit einem höheren Freiheitsgrad bestimmt werden.

Um die zweite Anzahl n dennoch gering zu halten, und damit den Rechenaufwand zu reduzieren, kann die zweite Anzahl n um eins größer gewählt werden als die Anzahl der verschiedenen zu bestimmenden Parameter.

Auf Basis der n bestimmten ähnlichsten Vergleichssignalverläufe d werden die Werte P der zu bestimmenden gewünschten Parameter bestimmt (Block 109). Insbesondere werden die den n bestimmten ähnlichsten Vergleichssignalverläufe zugeordneten Parameterwerte für die Bestimmung der Werte P der zu bestimmenden Parameter des Bildpunktes der Bildpunkt-Zeit-Serie BZS herangezogen.

Das Bestimmen der Werte P der zu bestimmenden Parameter auf Basis der n bestimmten ähnlichsten Vergleichssignalverläufe d kann eine Mittelung umfassen. Somit kann ein Wert P eines zu bestimmenden Parameters z.B. durch eine Mitteilung über die den n bestimmten ähnlichsten Vergleichssignalverläufen entsprechenden Werte, bestimmt werden.

Das Bestimmen der Werte P der zu bestimmenden Parameter auf Basis der n bestimmten ähnlichsten Vergleichssignalverläufe d kann auch eine Wichtung umfassen. Dadurch kann das Ergebnis der Bestimmung des Parameterwertes ggf., z.B. einer erwarteten Zuverlässigkeit der einzelnen Werte gemäß, beeinflusst werden.

Die Wichtung kann insbesondere auf Basis der bestimmten Ähnlichkeitswerte V bestimmt werden, wodurch ein Ergebnis der Bestimmung eines Parameterwertes näher an denjenigen Werten der n bestimmten ähnlichsten Vergleichssignale d liegen würde, die eine höhere Übereinstimmung und damit eine höhere Ähnlichkeit haben.

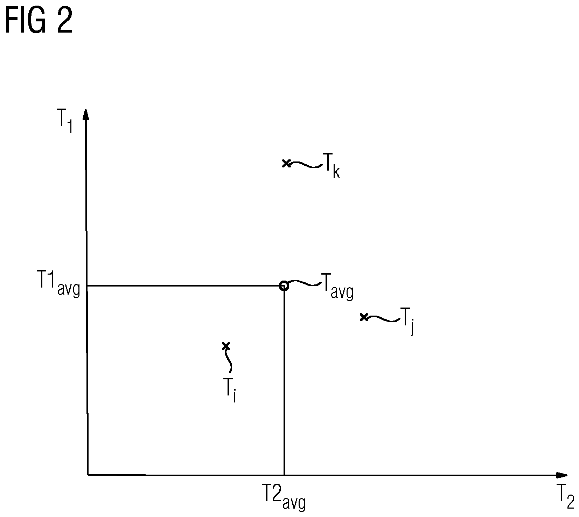

Figur 2 veranschaulicht eine mögliche Bestimmung von Parameterwerten auf Basis von bereits bestimmten ähnlichsten Vergleichssignalverläufen an dem einfachen Beispiel einer Bestimmung der Werte von hier zweie Parametern T₁ und T₂. Wie bereits oben ausgeführt, können die beiden Parameter beispielsweise die Transversalrelaxation T2 und die Longitudinalrelaxation T1 sein. Es können jedoch beliebige andere mittels MRF-Techniken gleichzeitig bestimmbare Parameter bestimmt werden.

In dem dargestellten Beispiel wurden für eine Bildpunkt-Zeit-Serie BZS die drei ähnlichsten Vergleichssignalverläufe d₁, d₂, d₃ mit den höchsten Ähnlichkeitswerten V₁, V₂ und V₃ bestimmt. Die Ähnlichkeit V wurde z.B. jeweils über Bildung des inneren Produkts V₁ = <BZS,d₁>, V₂ = <BZS,d₂> und V₃ = <BZS,d₃> bestimmt.

Die den ähnlichsten Vergleichssignalverläufen d₁, d₂, d₃ zugehörigen Parameterwerte-Tupel Tᵢ, Tⱼ und Tₖ, die für je ein Wertepaar T₁-T₂ der betrachteten Parameter stehen, liegen in Figur 2 an den durch Kreuze markierten Stellen in dem aufgespannten T₁-T₂-Koordinatensystem, und sind somit die n (hier n=3) besten Werte-Tupel.

Das Ergebnis der Bestimmung der Werte der Parameter T₁ und T₂ kann dann z.B. wie abgebildet aus dem Mittelwert, z.B. dem arithmetischen Mittelwert, der Werte-Tupel Tᵢ, Tⱼ und Tₖ als Ergebnis-Tupel T_{avg} bestimmt werden.

Wie bereits erwähnt, kann durch Verwendung von zusätzlichen Wichtungsfaktoren bei der Mittelung z.B. die Ähnlichkeit (definiert über das innere Produkt p) berücksichtigt werden. Beispielsweise könnte T_{avg} bestimmt werden als T_{avg} = Mittelwert (<V_{1,2,3}, T_{i,j,k}>). Dadurch würde das Ergebnis T_{avg} näher bei den Werten hoher Übereinstimmung mit den Vergleichssignalverläufen d1, d2, d3 des Dictionarys liegen.

Durch das erfindungsgemäße Vorgehen kann die Größe des Dictionarys reduziert werden, da die Ergebnisse nicht mehr auf das Gitter des Dictionarys reduziert sind. Der Zeitaufwand für Simulations- und Rekonstruktionsprozess kann also erheblich reduziert werden.

Durch das erfindungsgemäße Verfahren können Parameterwerte mit einer Auflösung bestimmt werden, die höher ist als die bei der Erstellung des Dictionarys für die Vergleichssignalverläufe verwendete Auflösung des Rasters an bestimmten Werten.

Die für den jeweiligen Bildpunkt bestimmten Werte P der zu bestimmenden Parameter können, z.B. in Form einer Parameterkarte, gespeichert und/oder ausgegeben, z.B. auch an einer Ein-/Ausgabeeinrichtung E/A einer Magnetresonanzanlage oder an einem sonstigen Display angezeigt werden (Block 111).

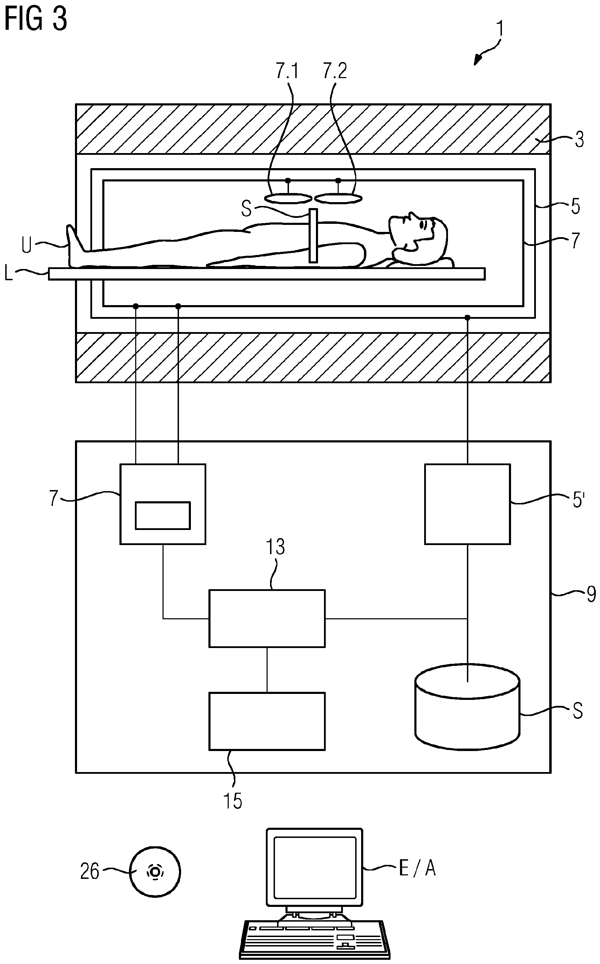

Figur 3 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9.

In der Figur 3 sind diese Teileinheiten der Magnetresonanzanlage 1 nur grob schematisch dargestellt. Insbesondere kann die Hochfrequenzeinheit 7 aus mehreren Untereinheiten, beispielsweise aus mehreren Spulen wie den schematisch gezeigten Spulen 7.1 und 7.2 oder mehr Spulen bestehen, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden. Die Schicht S stellt ein exemplarisches Zielvolumen des Untersuchungsobjekts dar, aus dem Messdaten aufgenommen werden sollen.

Die Steuereinrichtung 9 dient der Steuerung der Magnetresonanzanlage und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Bereich (beispielsweise in zu messenden Schichten S) des Untersuchungsobjekts U zuständig. Dabei wird die Mittenfrequenz des, auch als B1-Feld bezeichneten, Hochfrequenz-Wechselfeldes in aller Regel möglichst so eingestellt, dass sie nahe der Resonanzfrequenz der zu manipulierenden Spins liegt. Abweichungen von der Mittenfrequenz von der Resonanzfrequenz werden als Off-Resonanz bezeichnet. Zur Erzeugung des B1-Feldes werden in der Hochfrequenzeinheit 7 mittels der Hochfrequenz-Sende-/Empfangs-Steuerung 7' gesteuerte Ströme an den HF-Spulen angelegt.

Weiterhin umfasst die Steuereinrichtung 9 eine Parameterwertbestimmungseinheit 15, mit welcher erfindungsgemäße Signalvergleiche zur Bestimmung von Parameterwerten durchgeführt werden können. Die Steuereinrichtung 9 ist insgesamt dazu ausgebildet, ein erfindungsgemäßes Verfahren durchzuführen.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogrammprodukts vorliegen, welches ein Programm umfasst und das beschriebene Verfahren auf einer Steuereinrichtung 9 implementiert, wenn es auf der Steuereinrichtung 9 ausgeführt wird. Ebenso kann ein elektronisch lesbarer Datenträger 26 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 26 in einer Steuereinrichtung 9 einer Magnetresonanzanlage 1 das beschriebene Verfahren durchführen.

## Patentansprüche

1. Verfahren zur Bestimmung von Parameterwerten (P) in Bildpunkten eines Untersuchungsobjektes mittels einer Magnetresonanz-Fingerprinting(MRF)-Technik, umfassend die Schritte:
- Laden von einer Anzahl N an Vergleichssignalverläufen (D), die jeweils vorgegebenen Werten der zu bestimmenden Parameter zugeordnet sind,
- Erfassen mindestens einer Bildpunkt-Zeit-Serie (BZS) des Untersuchungsobjekts mit Hilfe eines MRF-Aufnahmeverfahrens, die mit den geladenen Vergleichssignalverläufen vergleichbar sind,
- Durchführen eines Signalvergleichs (105) mindestens eines Abschnitts des jeweiligen Signalverlaufs der erfassten Bildpunkt-Zeit-Serien (BZS) mit einem entsprechenden Abschnitt der geladenen Vergleichssignalverläufe (D) zur Ermittlung von Ähnlichkeitswerten (V) der erfassten Bildpunkt-Zeit-Serie (BZS) mit den geladenen Vergleichssignalverläufen (D),
- Bestimmen einer zweiten Anzahl n, wobei 2 ≤ n (≤ N), von ähnlichsten Vergleichssignalverläufen (d) der geladenen Vergleichssignalverläufen (D) mit den n höchsten bestimmten Ähnlichkeitswerten (V),
- Bestimmen der Werte (P) der zu bestimmenden Parameter auf Basis der n bestimmten ähnlichsten Vergleichssignalverläufe (d),
- Speichern und/oder Ausgeben der für den jeweiligen Bildpunkt bestimmten Werte (P) der zu bestimmenden Parameter.

2. Verfahren nach Anspruch 1, wobei die zweite Anzahl n größer ist als die Anzahl der verschiedenen zu bestimmenden Parameter.

3. Verfahren nach einem der vorhergehenden Ansprüche, wobei die zweite Anzahl n um eins größer ist als die Anzahl der verschiedenen zu bestimmenden Parameter.

4. Verfahren nach einem der vorhergehenden Ansprüche, wobei ein Bestimmen eines Ähnlichkeitswerts (V) einer erfassten Bildpunkt-Zeit-Serie (BZS) mit einem der geladenen Vergleichssignalverläufe (D) eine Berechnung des inneren Produkts der Bildpunkt-Zeit-Serie (BZS) und des geladenen Vergleichssignalverlaufs (D) umfasst.

5. Verfahren nach einem der vorhergehenden Ansprüche, wobei die Bestimmung der Werte (P) der zu bestimmenden Parameter auf Basis der n bestimmten ähnlichsten Vergleichssignalverläufe (d) eine Mittelung umfasst.

6. Verfahren nach einem der vorhergehenden Ansprüche, wobei die Bestimmung der Werte (P) der zu bestimmenden Parameter auf Basis der n bestimmten ähnlichsten Vergleichssignalverläufe (d) eine Wichtung umfasst.

7. Verfahren nach Anspruch 6, wobei die Wichtung auf Basis der bestimmten Ähnlichkeitswerte (V) bestimmt wird.

8. Verfahren nach einem der vorhergehenden Ansprüche, wobei die geladenen Vergleichssignalverläufe (D) eine Untergruppe von vorhandenen Vergleichssignalverläufen (D') sind.

9. Verfahren nach einem der vorhergehenden Ansprüche, wobei die geladenen Vergleichssignalverläufe (D) komprimierte Vergleichssignalverläufe sind.

10. Magnetresonanzanlage (1) umfassend, eine Magneteinheit (3), eine Gradienteneinheit (5), eine Hochfrequenzeinheit (7) und eine Steuereinrichtung (9) mit einer Hochfrequenz-Sende-/Empfangs-Steuerung (7') und einer Parameterwertbestimmungseinheit (15), wobei die Steuereinrichtung (9) dazu ausgebildet ist, ein Verfahren nach einem der Ansprüche 1 bis 9 auf der Magnetresonanzanlage (1) auszuführen.

11. Computerprogramm, welches direkt in einen Speicher einer Steuereinrichtung (9) einer Magnetresonanzanlage (1) ladbar ist, mit Programm-Mitteln, um die Schritte des Verfahrens nach einem der Ansprüche 1 bis 9 auszuführen, wenn das Programm in der Steuereinrichtung (9) der Magnetresonanzanlage (1) ausgeführt wird.

12. Elektronisch lesbarer Datenträger mit darauf gespeicherten elektronisch lesbaren Steuerinformationen, welche zumindest ein Computerprogramm nach Anspruch 11 umfassen und derart ausgestaltet sind, dass sie bei Verwendung des Datenträgers in einer Steuereinrichtung (9) einer Magnetresonanzanlage (1) ein Verfahren nach einem der Ansprüche 1 bis 9 durchführen.
